# EUROPEAN PATENT APPLICATION

(11) **EP 1 220 322 A2**
(43) Date of publication of application: **03.07.2002**
(21) Application number: 01310874.1
(22) Date of filing: 24.12.2001
(51) Int. Cl.: H01L 29/739

(54) **High breakdown-voltage semiconductor device**

(30) Priority: 27.12.2000 JP 2000399297
(71) Applicant: Kabushiki Kaisha Toshiba, Tokyo 105-8001 (JP)
(72) Inventor: Kobayashi, Motoshige, Intell. Property Division, Tokyo 105-8001 (JP); Nozaki, Hideki, c/o Intell. Property Division, Tokyo 105-8001 (JP)
(74) Representative: Granleese, Rhian Jane

(57) **Abstract**

An insulated gate bipolar transistor is disclosed, which comprises a first conductivity type base layer (1), a second conductivity type base layer (2) and an emitter layer (3) which are selectively formed in an upper surface of the first conductivity type base layer (1), a buffer layer (8) and a collector layer (9) which are formed on a back surface of the first conductivity type base layer (1). A requirement of d2/d1 > 1.5 is satisfied, where d1 is a depth in the buffer layer (8), as measured from an interface of the buffer layer (8) and the collector layer (9), at which a first conductivity type impurity concentration in the buffer layer (8) shows a peak value, and d2 is a shallowest depth in the buffer layer (8), as measured from the interface of the buffer layer (8) and the collector layer (9), at which an activation ratio of the first conductivity type impurity in the buffer layer (8) is a predetermined value.

## Description

This invention relates to a semiconductor device including a high breakdown-voltage semiconductor element such as punched-through type IGBT (Insulated Gate Bipolar Transistor).

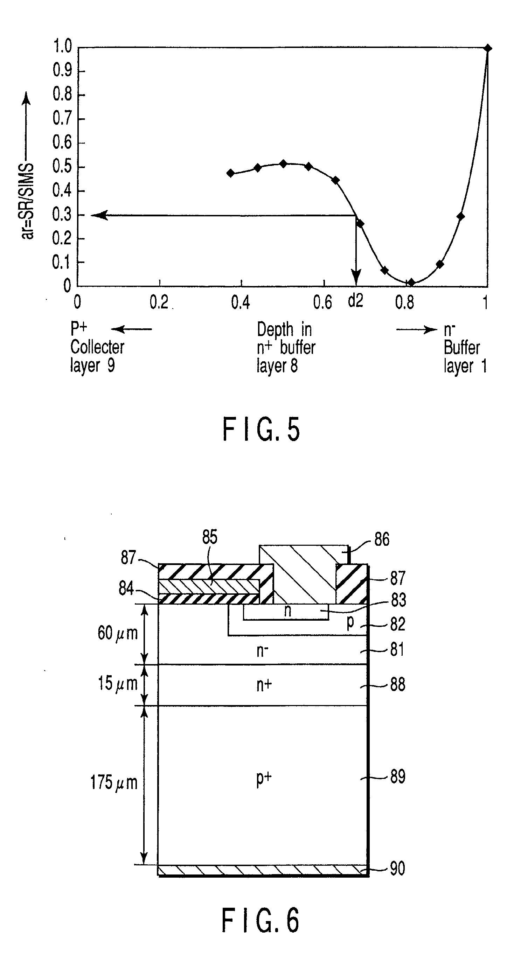

IGBTs are known as a type of high breakdown-voltage semiconductor elements. FIG. 6 of the accompanying drawing shows a schematic cross sectional view of a known punched-through type IGBT. In FIG. 6, reference symbol 81 denotes an n⁻-type base layer having a high electric resistance. A p-type base layer 82 is selectively formed in the surface of the n⁻-type base layer 81. An n-type emitter layer 83 is selectively formed in the surface of the p-type base layer 82.

A gate insulating film 84 is formed on a part of the p-type base layer 82 sandwiched by the n-type emitter layer 83 and the n⁻-type base layer 81 and a gate electrode 85 is formed on the gate insulating film 84. The gate electrode 85 is made of such as polysilicon. An interlayer insulating film 87 is formed over the surface of the semiconductor element.

An emitter electrode 86 is formed on the n-type emitter layer 83 and the p-type base layer 82 via the contact hole formed in the interlayer insulating film 87. The emitter electrode 86 is made of metal such as aluminum (A1). The emitter electrode 86 and the interlayer insulating film 87 are partly covered by a passivation film (not shown).

On the other hand, an n⁺-type buffer layer 88 is provided on the back surface of the n⁻-type base layer 81 and a p⁺-type collector layer 89 is provided on the back surface of the n⁺-type buffer layer 88. A collector electrode 90 is formed on the back surface of the p⁺-type collector layer 89. The collector electrode 90 is made of metal such as Al.

For manufacturing a punched-through type IGBT having the above described structure, a thick epitaxial wafer (substrate) already provided thereon with an n⁺-type buffer layer 88 and an n⁻-type base layer 81 that are formed on a p⁺-type collector layer 89 by an epitaxial growth process is used as semiconductor substrate for forming the device. However, an epitaxial growth process is accompanied by certain strict conditions and, thus such an epitaxial wafer is costly. As a matter of course, a semiconductor device (punched-through type IGBT) manufactured by using such an epitaxial wafer is costly.

An epitaxial wafer is typically manufactured by forming on an about 625 µm thick p⁺-type collector layer 89 an about 15 µm thick n⁺-type buffer layer 88 and an about 60 µm thick n⁻-type base layer 81 by epitaxial growth, whose overall thickness of about 700 µ m, and subsequently polishing the back surface of the p⁺-type collector layer 89 to reduce the thickness of the p⁺-type collector layer 89 to about 175 µm.

The epitaxial wafer prepared in these steps is then used as a wafer in which a punched-through type IGBT is to be formed. However, since the epitaxial wafer prepared in these steps is costly, the semiconductor device, i.e. a punched-through type IGBT, manufactured by using such an epitaxial wafer as semiconductor substrate is also costly.

This problem can be overcome by using a so called raw Si wafer that is not provided with an n⁺-type buffer layer 88 and a p⁺-type collector layer 89. The raw Si wafer is also referred to as a mirror-polished wafer. The raw Si wafer is a conductivity type semiconductor wafer having a substantially uniform impurity concentration.

When a raw Si wafer is employed, an n⁻-type wafer 81 is prepared as the raw Si wafer, and the n⁻-type wafer 81 is used as an n⁻-type base layer 81.

Then, a p-type base layer 82 is selectively formed in the surface of the n⁻-type base layer 81 and then an n-type emitter layer 83 is selectively formed in the surface of the p-type base layer 82. Subsequently, a gate insulating film 84, a gate electrode 85, an interlayer insulating film 87, an emitter electrode 86 and a passivation film (not shown) are sequentially formed.

Thereafter, the wafer is subjected to grinding and wet etching from the back surface thereof so that the thickness is thinned, and then an n-type impurity and a p-type impurity are sequentially implanted into the back surface of the n⁻-type base layer 81 by ion implantation. An annealing is performed to activate the n-type impurities and p-type impurities introduced by ion implantation to form an n⁺-type buffer layer 88 and a p⁺-type collector layer 89.

However, the anneal temperature and the anneal time of the above described annealing process for forming the n⁺-type buffer layer 88 and a p⁺-type collector layer 89 are subjected to limitations. More specifically, when the annealing process is conducted at high temperature for a long period of time, the emitter electrode 86 and the passivation film are exposed to high temperature, which adversely affects the emitter electrode 86 and the passivation film. In view of the possible adverse effect to the emitter electrode 86 and the passivation film, the annealing temperature needs to be relatively low, and the upper limit of annealing temperature is typically about 500°C when a thermal heating anneal is employed. However, the implanted n-type and p-type impurities cannot be activated satisfactorily with annealing temperature of about 500°C.

The temperature of the back surface of the n⁻-type base layer 81 can be raised to a level good for an Si melting temperature without exposing the surface of the n⁻-type base layer 81 to heat when a laser annealing process of irradiating a laser beam from the back surface of the n⁻-type base layer 81 is used for annealing. Therefore, the implanted n-type and p-type impurities can be satisfactorily activated without adversely affecting the emitter electrode 86 and the passivation film by using a laser annealing process.

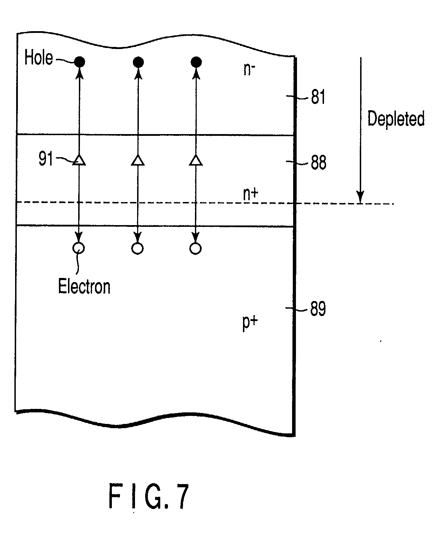

However, with a laser annealing process, the laser beam can only melt the n⁻-type base layer 81 only to a depth of about several microns (µm) and the laser beam irradiation time is very short. Therefore, the heat generated by the laser beam is not transmitted satisfactorily to the inside of the n⁺-type buffer layer 88. Further, damaged layers occurred due to the implantation can remain. As a result, a leak current will occur in a state where the semiconductor element is in an electrically off state because the residual damaged layers 91 (see FIG. 7) are depleted to act as carrier generators. Thus, a leak current can flow when the semiconductor element is in an electrically off state.

As described above, punched-through type IGBTs using an epitaxial wafer entails the problem of a high manufacturing cost. Punched-through type IGBTs using a raw Si wafer have been proposed to avoid the cost problem. However, when punched-through type IGBTs are formed by implanting ions into the n⁺-type buffer layer and the p⁺-type collector layer and annealing the ions by means of a laser annealing process, a leak current can occur in the device in an electrically off state.

According to an embodiment of the present invention, there is provided a semiconductor device comprising a first conductivity type base layer; a second conductivity type base layer selectively formed on a surface region of the first conductivity type base layer; a first conductivity type emitter layer selectively formed on a surface region of the second conductivity type base layer; a gate electrode formed on a part of the second conductivity type base layer sandwiched between the first conductivity type emitter layer and the first conductivity type base layer, with a gate insulating film interposed between the second conductivity type base layer and the gate electrode; a first conductivity type buffer layer formed on the back surface of the first conductivity type base layer; and a second conductivity type collector layer formed on the first conductivity type buffer layer, wherein a requirement of d2/d1 > 1.5 is satisfied, where d1 is a depth in the first conductivity type buffer layer, as measured from an interface of the first conductivity type buffer layer and the second conductivity type collector layer, at which a first conductivity type impurity concentration in the first conductivity type buffer layer shows a peak value, and d2 is a shallowest depth in the first conductivity type buffer layer, as measured from the interface of the first conductivity type buffer layer and the second conductivity type collector layer, at which an activation ratio of the first conductivity type impurity in the first conductivity type buffer layer is a predetermined value.

This summary of the invention does not necessarily describe all necessary features so that the invention may also be a sub-combination of these described features.

The invention can be more fully under stood from the following detailed description when taken in conjunction with the accompanying drawings, in which:
FIGS. 1A through 1E are schematic cross sectional views of an embodiment of semiconductor device according to the present invention, which is a punched-through type IGBT, in different manufacturing steps.
FIG. 2 is a schematic perspective partial view of a semiconductor structure, illustrating a process of SR analysis for analyzing impurities in an impurity diffusion layer by applying a pair of needles to a polished surface of the impurity diffusion layer.
FIG. 3 is a graph illustrating the impurity concentration distribution in the p⁺-type collector layer 9 and the n⁺-type buffer layer 8 of the semiconductor device in FIG. 1E.
FIG. 4 is a graph showing the relationship between d2/d1 and the leak current, where d1 is the depth in the n⁺-type buffer layer 8, as measured from the interface of the n⁺-type buffer layer 8 and the p⁺-type collector layer 9, at which the n-type impurity concentration in the n⁺-type buffer layer 8 shows a peak value, and d2 is the shallowest depth in the n⁺-type buffer layer 8, as measured from the interface of the n⁺-type buffer layer 8 and the p⁺-type collector layer 9, at which the activation ratio ar of the n-type impurity in the region of the n⁺-type buffer layer 8 is 0.3.
FIG. 5 is a graph illustrating the depth dependency of the activation ratio ar of the n-type impurity in the n⁺-type buffer layer 8.
FIG. 6 is a schematic cross sectional view of a known punched-through type IGBT.
FIG. 7 is a schematic illustration of the mechanism of occurrence of a leak current in a known punched-through type IGBT.

Now, a punched-through type IGBT according to an embodiment of the present invention will be described by referring to the accompanying drawings.

In this embodiment, a punched-through type IGBT is formed on a semiconductor substrate, which is a raw Si wafer. Since in this embodiment a raw Si wafer is used, the manufacturing cost of the embodiment is lower than that of a comparable device formed by using an epitaxial wafer.

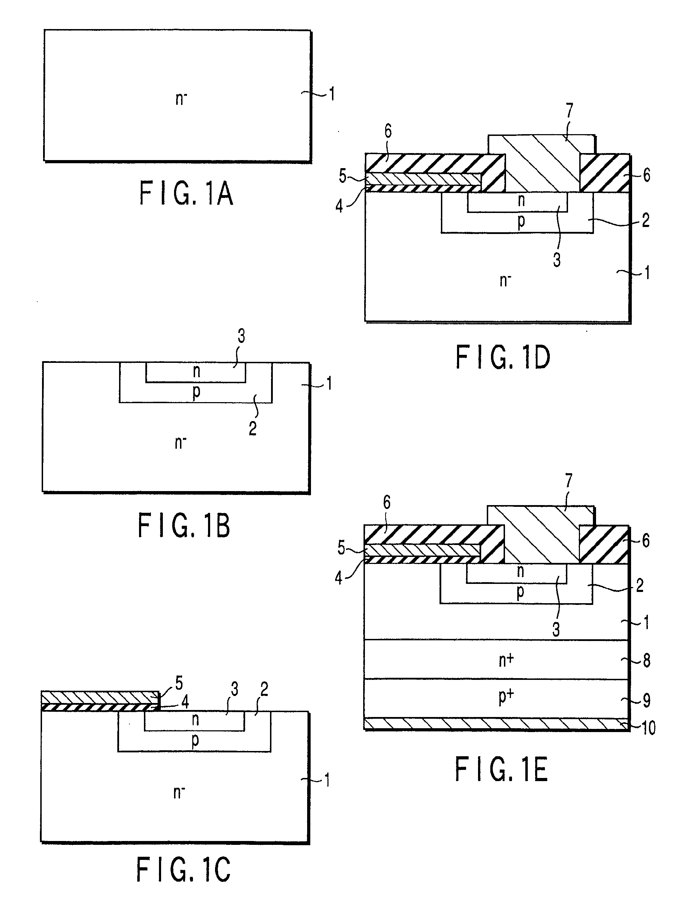

FIGS. 1A through 1E are schematic cross sectional views of a punched-through type IGBT according to an embodiment of the invention, which are in different manufacturing steps.

Firstly, an n⁻-type raw Si wafer 1 is prepared, as shown in FIG. 1A, and is used as n⁻-type base layer 1. The raw wafer is an n⁻-type semiconductor wafer having a substantially uniform impurity concentration.

Thereafter, as shown in FIG. 1B, a p-type base layer 2 is selectively formed in an upper surface of the n⁻-type base layer 1. Subsequently, an n-type emitter layer 3 is selectively formed in a surface of the p-type base layer 2. Thus, a p-type impurity diffusion layer 2 and an n-type impurity diffusion layer 3 are formed on the upper surface of the n⁻-type base layer 1.

Then, an insulating film and a conductive film are sequentially formed over the surface of the wafer 1 by thermal oxidizing and vapor deposition, respectively. The insulating film and the conductive film thus formed are subjected to a patterning process to form a gate insulating film 4 and a gate electrode 5 as shown in FIG. 1C. The gate electrode 5 is provided on the part of the p-type base layer 2 sandwiched between the n-type emitter layer 3 and the n⁻-type base layer 1 with the gate insulating film 4 interposed between the gate electrode 5 and the p-type base layer 2. The gate insulating film 4 is typically made of silicon oxide film, whereas the gate electrode 5 is typically made of polysilicon.

Then, an interlayer insulating film 6 is formed by vapor deposition over the surface of the wafer 1, i.e., on the exposed upper surface part of the wafer, the gate insulating film 4 and a gate electrode 5. Thereafter, a contact hole extending to the p-type base layer 2 and the n-type emitter layer 3 is formed in the interlayer insulating film 6 and subsequently an emitter electrode 7 is formed in the contact hole, as shown in FIG. 1D. The emitter electrode 7 is in contact with the p-type base layer 2 and the n-type emitter layer 3. The emitter electrode 7 is typically made of aluminum Al.

Thereafter, a passivation film (not shown) is formed over the surface of the wafer 1, i.e., on the interlayer insulating film 6 and the emitter electrode 7. Subsequently, the n⁻-type base layer 1 is thinned in accordance with a specified breakdown-voltage. The thinning operation is conducted by polishing the back surface of the n⁻-type base layer 1 typically by means of grinding and wet etching.

Then, an n-type impurity such as phosphorus is implanted into the back surface of the n⁻-type base layer 1 at a dose of 1 × 10¹⁵cm⁻² by applying an acceleration voltage of 240 KeV and subsequently a p-type impurity such as boron is implanted also at a dose of 1 × 10¹⁵cm⁻² by applying an acceleration voltage of 50 KeV. Thereafter, a laser annealing operation, typically an excimer laser annealing is conducted. In the excimer laser annealing, an excimer laser beam is irradiated to the back surface of the n⁻-type base layer 1 with an energy density of 2.5J/cm² to melt a region of the n⁻-type base layer 1, which is from the back surface of the n⁻-type base layer 1 to a depth less than about 5 µm from the back surface of the n⁻-type base layer 1. As a result, an n⁺-type buffer layer 8 and a p⁺-type collector layer 9 are formed on the back side of the n⁻-type base layer 1, as shown in FIG. 1E. Thus, an n⁺-type impurity diffusion layer 8 and a p⁺-type impurity diffusion layer 9 are formed on the back side of the n⁻-type base layer 1. Thereafter, a collector electrode 10 is formed on the p⁺-type collector layer 9 by means of a known process.

In this embodiment, the n⁺-type buffer layer 8 and the p⁺-type collector layer 9 satisfy the relationship of d2/d1 > 1.5, where d1 is a depth in the n⁺-type buffer layer 8, as measured from the interface of the n⁺-type buffer layer 8 and the p⁺-type collector layer 9, at which the n-type impurity concentration in the n⁺-type buffer layer 8 shows a peak value, and d2 is the shallowest depth in the n⁺-type buffer layer 8, as measured from the interface of the n⁺-type buffer layer 8 and the p⁺-type collector layer 9, at which the activation ratio ar of the n-type impurity in the region of the n⁺-type buffer layer 8 is 0.3, d2 being greater than d1. The activation ratio ar is defined by the concentration of the activated n-type impurity as obtained by SR (spreading resistance) analysis/the concentration of the n-type impurity as obtained by SIMS (secondary ion mass spectrometry) analysis.

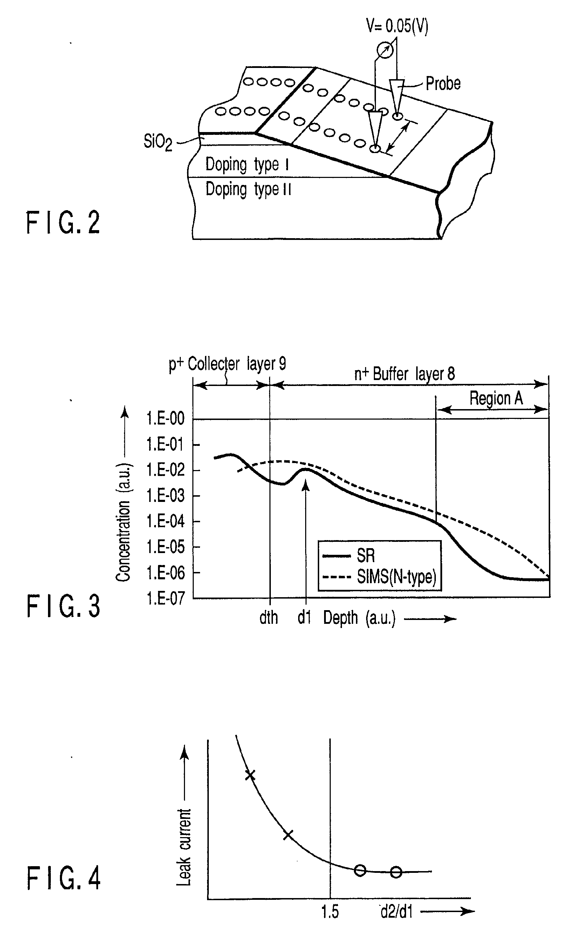

While the SR analysis method is well known, it will be briefly described below. The tips of a pair of needles (osmulum probe) whose gap is sufficiently reduced (to tens to hundreds of microns) are brought to contact the target (i.e., the impurity diffusion layer of Doping type I in FIG. 2) with a potential difference (e. g., 0.05V) between the two needles in order to cause an electric current flow through the impurity diffusion layer portion between the two needles. If the radius of the impurity diffusion layer portion contacting each of the tips of the needles is r, the relationship between the sheet resistance (Rs) and the specific resistance (ρ) is expressed by an equation of Rs = ρ/2r.

FIG. 2 schematically illustrates a process of SR analysis for analyzing the impurities in the impurity diffusion layer by applying a pair of needles to the slant-wise polished surface of the impurity diffusion layer, the tips of the needles being separated from each other by about 20 µm. In FIG. 2, Doping type II corresponds to the n⁺-type buffer layer 8 and Doping type I corresponds to the p⁺-type collector layer 9.

FIG. 3 is a graph illustrating the impurity concentration distribution in the n⁻-type base layer 1 and the n⁺-type buffer layer 8 of the semiconductor device of FIG. 1E. More specifically, in FIG. 3, the solid curve shows the n-type impurity concentration distribution obtained by an SR analysis, whereas the dotted curve shows the n-type impurity concentration distribution obtained by an SIMS analysis. In FIG. 3, region A is the region in the n⁺-type buffer layer 8 where damaged layers remain or both damaged layers and un-activated ions remain. The region A is produced in the process of implanting n-type impurity ions when forming the n⁺-type buffer layer 8. In FIG. 3, dth corresponds to the interface of the n⁺-type buffer layer 8 and the p⁺-type collector layer 9.

When the semiconductor element is in an electrically off state, part of the n⁺-type buffer layer 8 including the region A is depleted. Then, a large leak current flows when the region A is large. As described above, the region A is produced in the process of implanting n-type impurity ions when forming the n⁺-type buffer layer 8. Therefore, the region A is related to d2/d1. More specifically, the ratio of d2/d1 will be small when the region A is large. In other words, the region A is reduced to by turn reduce the leak current by increasing d2/d1.

Thus, the inventors of the present invention looked into the relationship between d2/d1 and the leak current and found out that the relationship as illustrated in FIG. 4 exists. The relationship shows that the leak current satisfactorily decreases when the ratio d2/d1 exceeds 1.5.

As described earlier, d2 is the shallowest depth in the n⁺-type buffer layer 8, as measured from the interface of the n⁺-type buffer layer 8 and the p⁺-type collector layer 9, at which the activation ratio ar of the n-type impurity in the region of the n⁺-type buffer layer 8 is 0.3, d2 being greater than d1. The reason why depth d2 is so defined is that the activation ratio ar of the n-type impurity in the n⁺-type buffer layer 8 changes from 0.5 to 0.1 sharply and the average of the activation ratio ar during this change is equal to 0.3 (= (0.5 + 0.1)/2), as shown in FIG. 5. However, another depth, for example 0.2, may be selected for d2. In FIG. 3, dth corresponds to the interface of the n⁺-type buffer layer 8 and the p⁺-type collector layer 9.

When the laser annealing conditions are changed without changing the ion implanting conditions of the n-type impurity in the process of forming the n⁺-type buffer layer 8, the depth up to which silicon is molten changes. Then, d2 changes while d1 is substantially fixed. Therefore, an activation ratio ar < 0.2 can be realized, without changing the conditions for implanting n-type impurity ions, by reducing the heating level of the laser annealing operation to reduce the depth up to which silicon is molten.

Note that the ratio of d2/d1 obtained by defining d2 as the depth at which the activation ratio is ar < 0.2 when the laser annealing conditions are changed without changing the ion implanting conditions of n-type impurity for forming the n⁺-type buffer layer 8 is larger than the ratio of d2/d1 obtained by defining d2 as the depth at which the activation ratio is ar < 0.3, d2 being greater than d1. In other words, the requirement of d2/d1 > 1.5 is met even when d2 is defined as the depth at which the activation ratio is ar < 0.2.

The present invention should not be limited to the above described embodiment. In the above described embodiment, the first conductivity type is n-type and the second conductivity type is p-type in the above description. However, the first conductivity type may be changed to p-type and the second conductivity type may be changed to n-type.

While in the above described embodiment the punched-through type IGBT is described as a discrete element, it may be formed with other circuits such as its control circuit and protection circuit in a same semiconductor chip.

Furthermore, while the embodiment of the present invention is described above in terms of a punched-through type IGBT, the present invention may be applied to a high breakdown voltage MOS transistor. In other words, the present invention may be applied to a layered semiconductor element or device having a structure of a first conductivity type base layer/a first conductivity type buffer layer/a second conductivity type collector layer.

As described above in detail, according to the invention, there is provided a semiconductor device such as a high breakdown-voltage semiconductor element that can effectively suppress any increase of the leak current.

The above described embodiment of the invention can be modified or altered in various different ways without departing from the scope of the invention.

## Claims

1. A semiconductor device **characterized by** comprising:
a first conductivity type base layer (1);
a second conductivity type base layer (2) selectively formed on an upper surface of said first conductivity type base layer (1);
a first conductivity type emitter layer (3) selectively formed on a surface of said second conductivity type base layer (2);
a gate electrode (5) formed on a part of said second conductivity type base layer (2) sandwiched between said first conductivity type emitter layer (3) and said first conductivity type base layer (1), with a gate insulating film (4) interposed between said second conductivity type base layer (2) and said gate electrode (5);
a first conductivity type buffer layer (8) formed on a back surface of said first conductivity type base layer (1); and
a second conductivity type collector layer (9) formed on a back surface of said first conductivity type buffer layer (8), wherein
a requirement of d2/d1 > 1.5 is satisfied, where d1 is a depth in said first conductivity type buffer layer (8), as measured from an interface of said first conductivity type buffer layer (8) and said second conductivity type collector layer (9), at which a concentration of a first conductivity type activated impurity in said first conductivity type buffer layer (8) shows a peak value, and d2 is a shallowest depth in said first conductivity type buffer layer (8), as measured from the interface of said first conductivity type buffer layer (8) and said second conductivity type collector layer (9), at which an activation ratio of said first conductivity type impurity in said first conductivity type buffer layer (8) is a predetermined value.

2. The semiconductor device according to claim 1, **characterized in that** said activation ratio is defined by a concentration of activated those of said first conductivity type impurity in said first conductivity type buffer layer (8)/a concentration of said first conductivity type impurity in said first conductivity type buffer layer (8).

3. The semiconductor device according to claim 2, **characterized in that** said concentration of said activated first conductivity type impurity in said first conductivity type buffer layer (8) is observed by a Spreading Resistance analysis and said concentration of said first conductivity type impurity in said first conductivity type buffer layer (8) is observed by a Secondary Ion Mass Spectrometry analysis.

4. The semiconductor device according to any preceding claim, **characterized in that** said predetermined value for said activation ratio is substantially 0.3 or lower than 0.3.

5. The semiconductor device according to any preceding claim, **characterized in that** said first conductivity type buffer layer (8) and said second conductivity type collector layer (9) are formed from impurity diffusion layers (8, 9).

6. The semiconductor device according to any of claims 1 to 4, **characterized in that** said first conductivity type buffer layer (8) and said second conductivity type collector layer (9) are formed by implanting impurities into and annealing a first conductivity type semiconductor wafer having a substantially uniform impurity concentration.

7. The semiconductor device according to any of claims 1 to 4, **characterized in that**
said first conductivity type base layer (1), said second conductivity type base layer (2), said first conductivity type emitter layer (3), said first conductivity type buffer layer (8) and said second conductivity type collector layer (9) are formed from impurity diffusion layers (1, 2, 3, 8, 9).

8. The semiconductor device according to any of claims 1 to 4, **characterized in that** said first conductivity type base layer (1), said second conductivity type base layer (2) and said first conductivity type emitter layer (3) are formed by implanting impurities into a first conductivity type semiconductor wafer having a substantially uniform impurity concentration, and said first conductivity type buffer layer (8) and said second conductivity type collector layer (9) are formed by implanting impurities into and annealing said semiconductor wafer.

9. The semiconductor device according to any preceding claim, **characterized in that** said depth d2 is larger than said depth d1.
